Europäisches Patentamt

European Patent Office

Office européen des brevets

(19)

(11) Publication number: **0 496 147 A1**

# EUROPEAN PATENT APPLICATION

(12)

(21) Application number: **91304170.3**

(22) Date of filing: **09.05.91**

(51) Int. Cl.5: **G01R 27/02**, G01R 35/00, G01R 27/14

(30) Priority: **25.01.91 US 645600**

(43) Date of publication of application:
**29.07.92 Bulletin 92/31**

(84) Designated Contracting States:
**DE FR GB NL**

(71) Applicant: **JOHN FLUKE MFG. CO., INC.**
**P.O. Box 9090**
**Everett Washington 98206-9090(US)**

(72) Inventor: **Allen, James F.**
6033 51st N.E.
Seattle, WA 98115(US)
Inventor: **Beckert, Richard D.**
8811 Valhalla Drive
Everett, WA 98208(US)
Inventor: **Rasnake, William F.**
20830 28th Avenue S.E.
Bothell, WA 98021(US)

(74) Representative: **Burke, Steven David et al**
R.G.C. Jenkins & Co. 26 Caxton Street
London SW1H 0RJ(GB)

(54) **Method of precise measurement of small resistance values.**

(57) A simple, low-cost method of precise measurement of small resistance values is provided in which increased current is available for producing high-resolution measurements, sufficient voltage headroom is provided to permit the system to respond in the presence of noise spikes and noise voltages and yet remain calibrated, line frequency noise is rejected, and test lead resistance is first determined and then subtracted out.

FIG. 3A

FIG. 3B

EP 0 496 147 A1

## Background of the Invention

This invention relates generally to ohm meters and resistance measuring systems, and in particular to a method of precise measurement of small resistance values.

Digital multimeters are well-known and very popular electronic instruments for measuring electrical quantities such as voltage, current, and resistance. For low ranges of resistance values, e.g., on the order of 10 ohms or less, special problems arise in making accurate resistance measurements. For example, when making measurements of small resistance values with 0.01-ohm resolution using $3\frac{1}{2}$ and $4\frac{1}{2}$ digit meters, an increased current from a precision constant current source is required. The resistance of test leads connected to the unknown resistance must be taken into account and either subtracted out or otherwise compensated for, particularly when measuring small resistance values that are comparable to the resistance values of such test leads. Other problems encountered in measuring small resistances include line frequency noise and other noise induced in the measuring circuits, and inability to handle large noise spikes or voltages on the unknown resistor. No single, complete solution to all of the foregoing problems has heretofore been available.

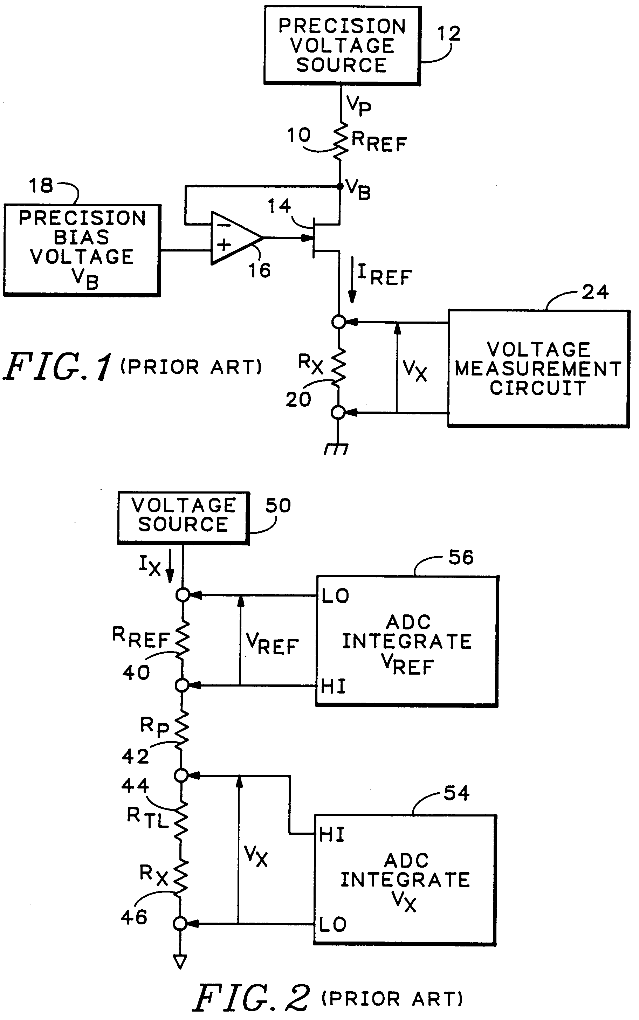

One conventional method of measuring the value of an unknown resistance by a measuring instrument such as a digital multimeter is to force a known current through the unknown resistance, measure the resultant voltage drop thereacross, and then display the measured voltage as an appropriately-scaled ohms reading. This technique is known in the art as "current source ohms." An example of this prior art technique, which provides only a partial solution to the foregoing problems, is embodied in the Fluke 8840A digital multimeter commercially available from John Fluke Mfg. Co., Inc. of Everett, Washington. These instruments include a way to zero out test lead resistance prior to making a measurement reading, and since a voltage measurement is made, line frequency noise is rejected. See Fig. 1 and accompanying detailed description. However, the circuitry required to accomplish low-resistance measurements is complicated, requires a large number of precision components.

Another prior art resistance measurement method, known in the art as "ratio ohms" and embodied in Fluke 45 and 80-series digital multimeters, determines the resistance value using a dual-slope integrating analog-to-digital converter to integrate the voltage across an unknown resistor and to integrate a reference voltage across a reference resistor (this latter integration is known in the industry as de-integrate or integrate-reference).

See Fig. 2 and the accompanying detailed description. The ratio of integrate and de-integrate times is equal to the ratio of the unknown resistance and reference resistance, so the value of the unknown resistance is easily determined by this simple technique. However, the increased current required to provide high-resolution, low-resistance measurements is generally not available using this technique, nor is the requisite voltage headroom to absorb noise spikes and overload voltages. Moreover, because the reference de-integrate time is variable, line frequency noise is not eliminated. Test lead resistance is compensated for by a software function.

A variant of the prior art "ratio ohms" technique is a technique known in the art as "flying capacitor ohms," wherein a capacitor, charged to the reference voltage, is switched into the measurement circuit during the de-integrate cycle to provide a subtraction and ratio technique to indirectly derive a ratio of the unknown resistance to the reference resistor. This technique is complex in operation and is subject to charge injection and peak detection. In addition, the requisite voltage headroom to absorb noise spikes and overload voltages is generally not available. An example of the "flying capacitor" technique is embodied in the commercially-available Fluke 8050A digital multimeter.

## Summary of the Invention

In accordance with the present invention, a simple, low-cost method of precise measurement of small resistance values is provided in which increased current is available for producing high-resolution measurements, sufficient voltage headroom is provided to permit the system to respond in the presence of noise spikes and overload voltages and yet remain calibrated, line frequency noise is rejected, and test lead resistance is first determined and then subtracted out.

The method utilizes an architecture similar to that for the "ratio ohms" technique--that is, a predetermined reference resistor, a protection resistor, test lead resistance, and an unknown resistor connected in series between a known (either predetermined or measured) D.C. voltage source and a reference level such as system ground--however, is operated differently. A series of calibration steps are made with the unknown resistor out of the circuit and with the test leads shorted together to determine the values of the protection resistor and test lead resistance (and D.C. source voltage if it is not predetermined). Then the voltage across the input terminals is measured with the unknown resistor in place, and with all the circuit parameters known, the value of the unknown resistor is calculated and made available for display. Because D.C. measurements are made, line frequency and noise are rejected.

It is therefore one object of the invention to provide a method of precise measurement of small resistance values.

It is another object of the present invention to provide a method of precise measurement of small resistance values in which increased current is available for producing high-resolution measurements, sufficient voltage headroom is provided to absorb noise spikes, and line frequency noise is rejected.

It is a further object of the present invention to provide a method of precise measurement of small resistance values that is simple, inexpensive, and can be retrofitted into an existing system.

It is yet another object of the present invention to provide a method of precise measurement of small resistance values that exhibits improved noise rejection.

It is yet a further object of the present invention to provide a calibrated high-noise-immunity small-resistance-measurement method.

Other objects, features, and advantages of the present invention will become obvious to those having ordinary skill in the art upon a reading of the following description when taken in conjunction with the accompanying drawings.

Brief Description of the Drawings

Fig. 1 is a schematic diagram of a prior art "current source ohms" technique for measuring small resistance values;

Fig. 2 is a schematic diagram of a prior art "ratio ohms" technique for measuring small resistance values;

Figs. 3A and 3B are schematic diagrams representing the calibration and measurement operations, respectively, of a system for measuring small resistance values in accordance with a preferred embodiment of the present invention; and

Figs. 4A and 4B are flow charts to explain the operations of the system of Figs. 3A and 3B, respectively.

Detailed Description of the Invention

Referring to Fig. 1 of the drawings, one example of a prior art technique known as "current source ohms" is shown for illustrative purposes. A precision reference resistor 10 having a predetermined value $R_{REF}$ is connected at one end to a precision D.C. voltage source 12, and at the other end to the source of a field-effect transistor (FET) 14 and the inverting input of an operational amplifier 16. The non-inverting input of operational amplifier 16 is connected to a precision bias voltage source 18, and the output of amplifier 16 is connected to the gate of FET 14. Through operational amplifier action, the source of FET 14 is held at the bias voltage $V_B$. Hence, the voltage dropped across reference resistor 10 is precisely $V_P - V_B$, the difference between the values supplied by the precision voltage source 12 and bias voltage source 18, developing through resistor 10 a stable constant reference current $I_{REF}$. The reference current $I_{REF}$ is forced through a resistor 20 having an unknown value $R_X$, developing a voltage $V_X$ thereacross. A voltage measurement circuit 24 measures the value of voltage $V_X$, and provides an appropriately-scaled reading or display in ohms.

Fig. 2 shows one example of another prior art technique known as "ratio ohms." Resistors 40, 42, 44, and 46 are connected in series between a voltage source 50 and ground. In this string of resistors, resistor 40 is a reference resistor having a value $R_{REF}$, resistor 42 is an overvolts protection resistor having a value $R_P$, resistor 44 represents the resistance of a pair of test leads having a value $R_{TL}$, and resistor 46 represents an unknown resistor having a value $R_X$. A constant current $I_X$ flows through all of the resistors in the string, and accordingly, the voltage drops $V_{REF}$ and $V_X$ developed across resistors 40 and 44 + 46, respectively, are proportional to $R_{REF}$ and $R_X + R_{TL}$, respectively, and $(R_X + R_{TL})/R_{REF} = V_X/V_{REF}$. A first integrating analog-to-digital converter (ADC) 54 is connected across resistors 44 and 46 to determine the value of $V_X$, and a second integrating ADC 56 is connected across resistor 40 to determine the value of $V_{REF}$. From these values, the value of $R_X + R_{TL}$ is calculated. Test lead resistance $R_{TL}$ is then compensated for by a software function, which if $R_X$ is very small, could lead to erroneous readings. It should be noted that with appropriate switching, ADCs 54 and 56 could be replaced with a single dual-slope integrating ADC.

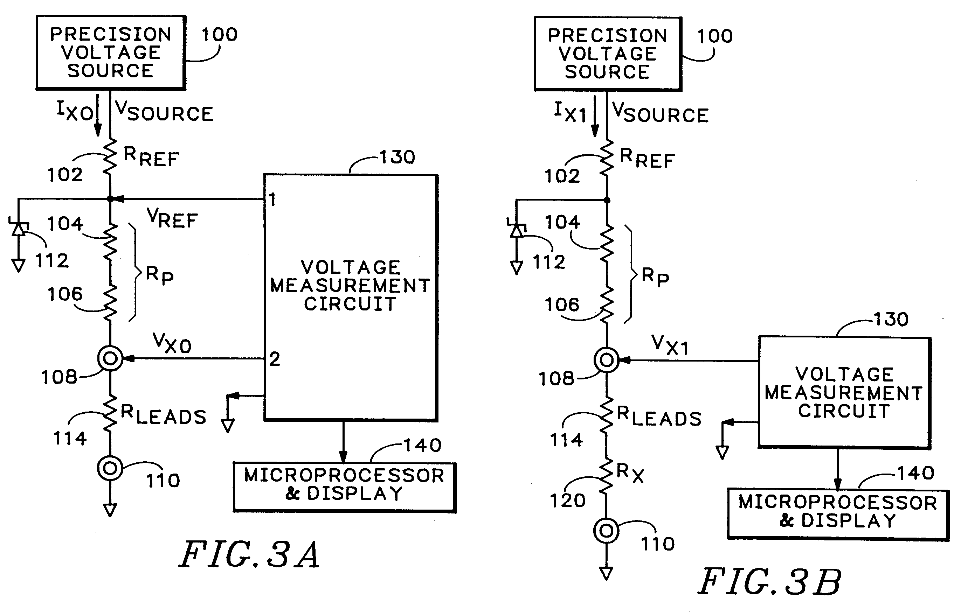

Referring now to the system of Figs. 3A and 3B, wherein like reference numerals are used for like components, there is shown a system similar to that discussed above in connection with the prior art "ratio ohms" technique of Fig. 2. A series circuit to ground from a precision voltage source 100 includes a reference resistor 102, a thermistor 104, a fusible resistor 106, and a pair of input terminals 108-110 with unknown resistance connected therebetween. The circuit may also include a voltage clamp 112, herein depicted as a Zener diode merely for schematic representation, to limit any positive-going voltage excursion and thereby provide overvoltage protection. In Fig. 3A, only test lead resistance 114 is shown connected between input terminals 108 and 110, while in Fig. 3B the series combination of test lead resistance 114 and an unknown resistor 120 are connected between the input terminals 108 and 110.

Precision D.C. voltage source 100 provides a predetermined voltage $V_{SOURCE}$ such as, for example, +3.100 volts. Reference resistor 102 has a predetermined close-tolerance value $R_{REF}$, such as, for example, 1.5 kilohm, within 1% tolerance. Thermistor 104, which limits current and provides overvoltage protection, and fusible resistor 106, which protects the input from current surges, in combination form a protection resistance having a value $R_P$. Thermistor 104, however, may vary widely over a temperature range and drift with changes in temperature, and thus is inherently not a precision component. In the proposed commercial embodiment, thermistor 104 has a value of 1.0 kilohm, within 40% tolerance, and fusible resistor 106 has a value of 1.0 kilohm, within 1%. The source voltage and resistance values mentioned above are for one particular implementation to ensure increased current for high-resolution measurements while providing sufficient headroom to absorb overvoltages and noise spikes, and may be chosen as desired for a given situation.

In Fig. 3A, a voltage measurement circuit 130, the details of which are conventional and well known to those skilled in the art, is connected to the junction of resistor 102 and thermistor 104, and to input terminal 108, to measure the voltages $V_{REF}$ and $V_{X0}$ at those points. The measured voltages are stored and subsequently processed by an associated microprocessor and display unit 140 to determine the protection resistance $R_P$ and any test lead resistance $R_{LEADS}$.

In Fig. 3B, voltage measurement circuit 130 is connected to terminal 108 to measure input voltage $V_{X1}$. Thereafter, the microprocessor and display unit 140 determines the value of the unknown resistor and displays the result.

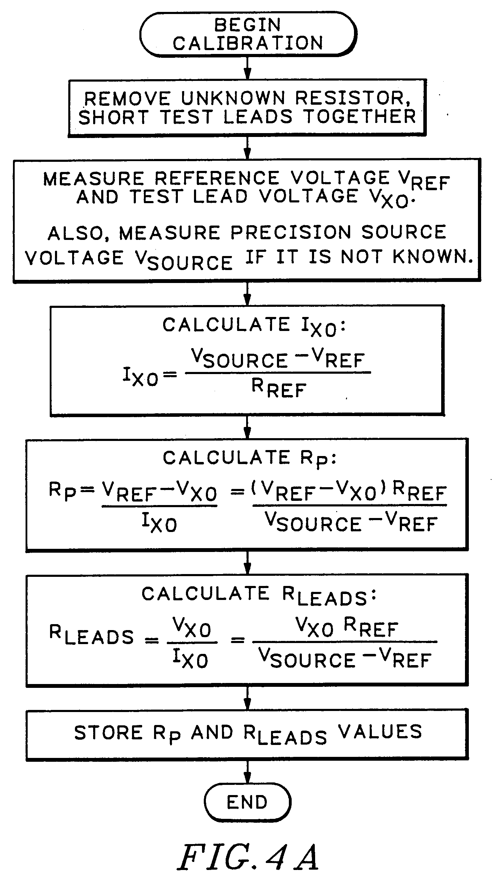

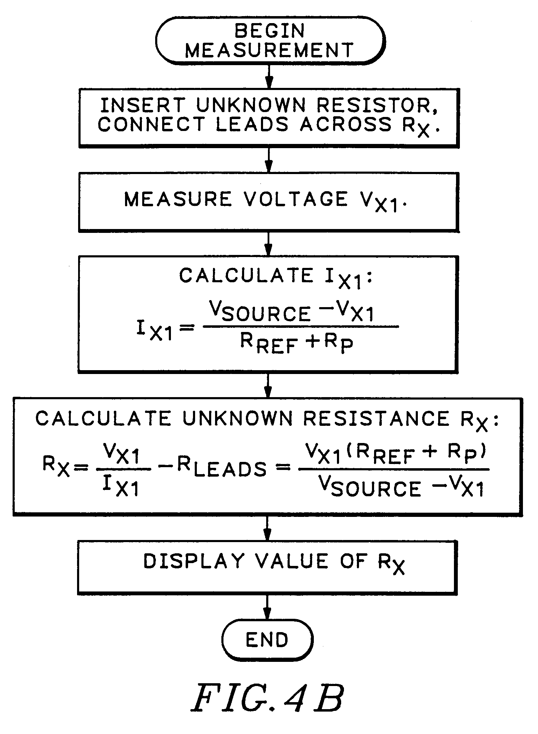

Calibration and measurement operations of the system of Figs. 3A and 3B, respectively, will be discussed in connection with the flow charts of Figs. 4A and 4B, respectively. The steps shown in Fig. 4A may be referred to as the calibration steps, and these steps are to determine the values of the protection and test leads resistances. The steps shown in Fig. 4B may be referred to as the measurement steps, and these steps are to determine the value of the unknown resistance once all the other circuit parameters are known.

To begin the calibration steps to determine the values of the protection and test lead resistances, the test leads are shorted together to provide a series circuit to ground through resistors 102, 104 and 106, connectors 108 and 110 and the test leads, the resistance $R_{LEADS}$ of which is represented schematically by resistor 114. Note that the unknown resistor is removed from the circuit during this step. With the test leads shorted together, two voltage measurements are made with respect to ground: $V_{REF}$ and $V_{X0}$. The value $V_{SOURCE}$ of the precision voltage source 100 is either predetermined or may be measured, and therefore known for purposes of the calibration steps and measurement steps described herein. The value $R_{REF}$ of the reference resistor 102 is also known. Therefore, the initial standing current through the series circuit, $I_{XO}$, may be calculated as follows:

(1)     $I_{X0} = (V_{SOURCE} - V_{REF})/R_{REF}$.

Next, the values $R_P$ and $R_{LEADS}$ of the protection resistors 104-106 and test lead resistance 114 are calculated as follows:

(2)     $R_P = (V_{REF} - V_{X0})/I_{X0}$, and

(3)     $R_{LEADS} = V_{X0}/I_{X0}$.

Once the values of the protection resistor and test lead resistance have been determined, these values may stored in memory as calibrated resistances to be used in the measurement of unknown resistance values. Thus the calibration steps do not have to be performed for each unknown resistance measurement; however, recalibration from time to time will ensure accuracy of the measurements. Of course, if the operating temperature of the system is not stable, e.g., at power-up, or if the test leads are changed or replaced, recalibration is necessary.

Referring now to Fig. 4B, the measurement steps begin with placing the unknown resistor 120 into the series circuit as shown in Fig. 3B. Voltage $V_{X1}$ is measured with respect to ground. This value may stored in memory, and used to calculate the standing current $I_{X1}$ through the series circuit. The value of current $I_{X1}$ is calculated as follows:

(4)     $I_{X1} = (V_{SOURCE} - V_{X1})/(R_{REF} + R_P)$.

Finally, the value of the unknown resistance $R_X$ is calculated as follows:

(5)     $R_X = (V_{X1}/I_{X1}) - R_{LEADS}$.

The value of the unknown resistance is then displayed either graphically or numerically in accordance with conventional display techniques.

It can be appreciated that the protection resistor may be an inexpensive and wide-tolerance (e.g., 40%) part, and that small resistance values may be measured without regard for test lead resistance. Also, since DC voltage measurements are made, line frequency and noise spikes are rejected.

While we have shown and described a preferred embodiment of our invention, it will be apparent to those skilled in the art that many changes and modifications may be made without departing from our invention in its broader aspects. For example, an existing measurement system easily may be modified to incorporate measurement and processing components to carry out the method described above. It is therefore contemplated that the appended claims will cover all such changes and modifications as fall within the true scope of the invention.

## Claims

1. In a system in which a predetermined reference resistor, at least one protection resistor, a test lead resistance, and an unknown resistance are connected in series between a D.C. source voltage and a reference level, a method of measuring the value of said unknown resistance, comprising the steps of:

   (a) determining the values of said at least one protection resistor and said test lead resistance;

   (b) measuring a voltage drop across the series combination of said unknown resistance and said test lead resistance;

   (c) calculating the standing current in said series circuit by subtracting said voltage drop from said source voltage to produce a resultant voltage, and dividing said resultant voltage by the combined values of said predetermined reference resistor and said at least one protection resistor; and

   (d) calculating the value of the unknown resistance by dividing said voltage drop by said standing current and subtracting the value of said test lead resistance.

2. A method in accordance with claim 1 further comprising the step of providing a display of said value of said unknown resistance.

3. A method in accordance with claim 1 wherein said step of determining the values of said at least one protection resistor and said test lead resistance further comprises the steps of:

   (e) measuring a first voltage dropped across the series combination of said at least one protection resistor and said test lead resistance with said unknown resistance removed from said system;

   (f) measuring a second voltage dropped across said test lead resistance with said unknown resistance removed from said system;

   (g) calculating the value of initial current through said series circuit with said unknown resistance removed from the system by subtracting said first voltage from said D.C. source voltage and dividing the difference by the value of said reference resistor;

   (h) calculating the value of said at least one protection resistor by subtracting said second voltage from said first voltage and dividing the result by the value of said initial current; and

   (i) calculating the value of said test lead resistance by dividing said second voltage by the value of said initial current.

4. A method in accordance with claim 3 wherein the values of said at least one protection resistor and said test lead resistance are stored.

5. A method of measuring a resistance value using a reference voltage source and a reference resistance, the method comprising measurement and calibration steps, the calibration step involving connecting the reference voltage source across a series circuit comprising the reference resistance and the test leads of a measurement instrument and measuring the voltage drop across said test leads so that the resistance of the test leads can be determined from this voltage drop, the value of the reference voltage and the value of the reference resistance, the measurement step involving connecting the reference voltage source across a series circuit comprising the reference resistance, the test leads and an unknown resistance connected to the measurement instrument via the test leads, and measuring the voltage drop across the combination of the test leads and the unknown resistance so that the combined resistance of the test leads and the unknown resistance can be determined from the voltage drop, the value of the reference voltage and the value of the reference resistance, whereby the value of the unknown resistance is calculated from the combined resistance value determined by the measurement step and the test lead resistance value determined from the calibration step.

6. A method as claimed in claim 5, wherein the series circuits in the measurement and calibration steps include a further resistance, and the calibration step further involves measuring the voltage across said further resistance so that its value can be determined, the value of the combined resistance measured in the measurement step thereby being calculable from the voltage drop across the combined resistance, the value of the reference voltage and the sum of the value of the reference resistance and the further resistance.

$FIG.1$ (PRIOR ART)

$FIG.2$ (PRIOR ART)

*FIG.3B*

*FIG.3A*

```
                    ┌──────────────┐
                    │    BEGIN     │
                    │ CALIBRATION  │
                    └──────┬───────┘
                           ▼
        ┌──────────────────────────────────┐
        │ REMOVE UNKNOWN RESISTOR,          │
        │ SHORT TEST LEADS TOGETHER         │
        └──────────────┬───────────────────┘
                       ▼
    ┌────────────────────────────────────────┐
    │ MEASURE REFERENCE VOLTAGE VREF          │
    │ AND TEST LEAD VOLTAGE VXO.              │
    │                                         │
    │ ALSO, MEASURE PRECISION SOURCE          │
    │ VOLTAGE VSOURCE IF IT IS NOT KNOWN.     │
    └───────────────────┬─────────────────────┘
                        ▼
```

CALCULATE $I_{XO}$:

$$I_{XO} = \frac{V_{SOURCE} - V_{REF}}{R_{REF}}$$

CALCULATE $R_P$:

$$R_P = \frac{V_{REF} - V_{XO}}{I_{XO}} = \frac{(V_{REF} - V_{XO})\, R_{REF}}{V_{SOURCE} - V_{REF}}$$

CALCULATE $R_{LEADS}$:

$$R_{LEADS} = \frac{V_{XO}}{I_{XO}} = \frac{V_{XO}\, R_{REF}}{V_{SOURCE} - V_{REF}}$$

STORE $R_P$ AND $R_{LEADS}$ VALUES

```
                    ┌──────────┐
                    │   END    │
                    └──────────┘
```

## FIG. 4A

BEGIN
MEASUREMENT

INSERT UNKNOWN RESISTOR,
CONNECT LEADS ACROSS $R_X$.

MEASURE VOLTAGE $V_{X1}$.

CALCULATE $I_{X1}$:

$$I_{X1} = \frac{V_{SOURCE} - V_{X1}}{R_{REF} + R_P}$$

CALCULATE UNKNOWN RESISTANCE $R_X$:

$$R_X = \frac{V_{X1}}{I_{X1}} - R_{LEADS} = \frac{V_{X1}(R_{REF} + R_P)}{V_{SOURCE} - V_{X1}}$$

DISPLAY VALUE OF $R_X$

END

*FIG.4B*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 360 605 (J.FLUKE)<br>* abstract; figure 1 *<br>* column 5, line 24 - line 26 * | 1 | G01R27/02<br>G01R35/00<br>G01R27/14 |
| Y | | 5 | |
| Y | US-A-4 323 972 (R.A.WINTER)<br>* abstract; figures 1-4 *<br>* column 1, line 26 - line 55 * | 5 | |
| A | IEEE INSTRUMENTATION AND MEASUREMENT TECHNOLOGY CONFERENCE<br>April 1988, SAN DIEGO, US<br>pages 292 - 296;<br>W.C.GOEKE: 'High Performance Digital Multimeter with "Internal Calibration"'<br>* page 292, left column, line 25 - line 28 *<br>* page 292, left column, line 34 - right column, line 2 *<br>* page 293, right column, line 32 - line 36 *<br>* page 296, left column, last paragraph - right column * | 1 | |
| A | MACHINE DESIGN.<br>vol. 59, no. 11, 14 May 1987, CLEVELAND US<br>pages 243 - 248; 'Multimeters'<br>* page 244, middle column, line 4 - line 8 *<br>* page 248, left column, paragraph 2 - middle column, paragraph 2 * | 1 | TECHNICAL FIELDS SEARCHED (Int. Cl.5)<br><br>G01R |
| A | DE-A-2 915 491 (SIEMENS)<br>* page 7, line 32 - page 8, line 1; figures 1,2 * | 1,5 | |

The present search report has been drawn up for all claims

| Place of search | Date of completion of the search | Examiner |
|---|---|---|
| BERLIN | 16 MARCH 1992 | S.C.Fritz |